# EUROPÄISCHE PATENTSCHRIFT

(11) **EP 0 700 630 B1**
(45) Veröffentlichungstag und Bekanntmachung des Hinweises auf die Patenterteilung: **05.02.2003**
(21) Anmeldenummer: 94908933.8
(22) Anmeldetag: 23.03.1994
(51) Int. Cl.: H05K 3/00

(54) **FOLIENLEITERPLATTEN UND VERFAHREN ZU DEREN HERSTELLUNG**
FOIL PRINTED CIRCUIT BOARDS AND METHOD OF PRODUCING THE SAME
CARTE A CIRCUIT IMPRIME EN FEUILLE MINCE ET PROCEDE DE FABRICATION

(43) Veröffentlichungstag der Anmeldung: 13.03.1996
(73) Patentinhaber: Dyconex AG, 8303 Bassersdorf (CH)
(72) Erfinder: MARTINELLI, Marco, CH-8413 Neftenbach (CH); SCHMIDT, Walter, CH-8050 Zürich (CH)
(74) Vertreter: Frei, Alexandra Sarah
(86) Internationale Anmeldenummer: CH9400062
(87) Internationale Veröffentlichungsnummer: WO95026122

(56) Entgegenhaltungen:
- EP-A- 0 534 290
- EP-A- 0 575 292
- WO-A-93/26143
- DE-A- 4 229 026
- US-A- 3 589 004

## Beschreibung

Die Erfindung liegt auf dem Gebiete der Leiterplattenherstellung und betrifft eine Folienleiterplatte gemäss dem Oberbegriff des ersten unabhängigen Patentanspruchs und ein Verfahren zur Herstellung dieser Folienleiterplatte gemäss dem Oberbegriff des entsprechenden unabhängigen Patentanspruchs.

Nach einer Folientechnik, wie sie beispielsweise in der internationalen Patentanmeldung mit der Veröffentlichungsnummer WO 93/26143 derselben Anmelderin beschrieben ist, werden aus ein- und/oder beidseitig mit beispielsweise Kupfer beschichteten Folien aus einem elektrisch isolierenden Material (z.B. Polyimid oder Epoxidharz) dünne Leiterplatten hergestellt. Die Herstellung dieser Folienleiterplatten besteht im wesentlichen darin, dass auf einer beidseitig beschichteten Folie nach bekannten photographischen und chemisch/physikalischen Methoden Leiterbahnen und Durchkontaktierungen erstellt werden. Eine so entstandene Leiterplatte mit einer Folienlage und zwei Leiterbahnenlagen kann mit Hilfe je einer Kleberschicht einseitig oder beidseitig mit einer weiteren Folie (einseitig mit Metall beschichtet) zusammenlaminiert werden, wobei die weitere Folie oder die weiteren Folien dann wiederum mit Leiterbahnen und Durchkontaktierungen versehen werden.

Diese Verfahrensschritte können beliebig wiederholt werden, wobei Folienleiterplatten bestehend aus einer Mehrzahl von Folienlagen und einer Mehrzahl von Leiterbahnenlagen entstehen.

Da derartige Folienleiterplatten sehr dünn und, insbesondere wenn sie aus wenigen Folienlagen bestehen, flexibel sind, werden sie vor der Bestückung üblichereise auf ein starres Substrat auflaminiert, wodurch Leiterplatten entstehen, die den üblichen Normen bezüglich Dicke und Format entsprechen.

Werden Folienleiterplatten aus mehreren Folienlagen aufgebaut, nimmt deren Flexibilität sehr stark ab, sodass derart auch ohne Substrat im Vergleich zu herkömmlichen Leiterplatten sehr dünne Leiterplatten hergestellt werden, die für eine Bestückung eine genügende Eigensteifigkeit aufweisen. Derartige Leiterplatten finden beispielsweise Anwendungen für "Multi chip modules".

Da nicht nur die elektronischen Bauelemente und die mit solchen bestückten Leiterplatten immer kleiner werden sollen, sondern auch die Apparate und Geräte, in denen solche Leiterplatten eingebaut werden, immer kleiner werden, wäre es in vielen Fällen vorteilhaft, wenn die Leiterplatten platzsparender in den Geräten untergebracht werden könnten, das heisst, wenn sie an die Geräteform oder wenigstens an die Form des ihnen zugewiesenen Geräteinnenraumes optimal anpassbar wären, also flexibel bzw. biegbar. Andererseits ist es nach wie vor für die Bestückung der Leiterplatten notwendig, Spannungen in den Verbindungen zwischen elektronischen Bauelementen und Leitern auf der Leiterplatte, die durch Deformationen der Leiterplatte entstehen können, durch eine genügende Steifigkeit der Leiterplatte zu verhindern.

Aus der deutschen Offenlegungsschrift 42 29 026 ist eine Leiterplatte bekannt, welche eine einzige Leiterbahnlage und auf beiden Seiten dieser Leiterbahnlage je eine Lage isolierenden Materials aufweist. Diese zwei Lagen isolierenden Lagen sind in Biegeabschnitten dickenvermindert, wodurch sie in diesen Abschnitten eine geringere Steifigkeit aufweisen.

Es ist nun die Aufgabe der Erfindung, Folienleiterplatten zu schaffen, die beide Bedingungen erfüllen, nämlich die Bedingung der Flexibilität bzw. Biegbarkeit für ihre Anpassung an ihre Umgebung und die Bedingung der Steifigkeit für ihre Bestückung. Ferner ist es eine Aufgabe der Erfindung, ein Verfahren aufzuzeigen, mit dem derartige Leiterplatten hergestellt werden können.

Diese Aufgabe wird gelöst durch die Folienleiterplatte und durch das Herstellungsverfahren zur Herstellung der Folienleiterplatte, wie sie in den Patentansprüchen definiert werden.

Die zentrale Idee der Erfindung beruht darauf, dass Folienleiterplatten geschaffen werden, die bereichsweise flexibel und bereichsweise starr sind, dadurch, dass in den flexiblen Bereichen gegenüber den starren Bereichen eine oder mehrere äussere Folienlagen unterbrochen sind oder eine verminderte Dicke aufweisen, derart, dass ein flexibler Bereich gesamthaft dünner ist als ein starrer Bereich. Die erfindungsgemässen Folienleiterplatten werden hergestellt, indem in einem Ätzschritt, vorzugsweise einem Plasmaätzschritt, einseitig oder beidseitig die äussersten Folienlagen der entstehenden Leiterplatte grösserflächig abgetragen werden, da, wo flexible Bereiche vorgesehen sind. Dieser Ätzschritt kann an der oder den zuletzt auflaminierten Folienlagen durchgeführt werden oder für weiter auflaminierte Folienlagen wiederholt werden. Das Verfahren ist insbesondere vorteilhaft, wenn in demselben Ätzschritt auch die für die Durchkontaktierungen notwendigen Öffnungen in der entsprechenden Folienlage erstellt werden.

Auf diese Weise entstehen Folienleiterplatten, die starre und flexible Bereiche aufweisen. Durch entsprechende Ausgestaltung des Überganges zwischen starrem und flexiblem Bereich kann dieser quasi kontinuierlich gemacht werden, womit beispielsweise verhindert wird, dass ein für eine Biegung vorgesehener flexibler Bereich am Übergang zum starren Bereich knickt. Der Dikkenunterschied oder der Unterschied in der Anzahl von Folienlagen zwischen starren und flexiblen Bereichen ist an sich beliebig und wird je nach Anwendung der Komplexität der elektronischen Schaltung (Anzahl Folienlagen im starren Bereich) und der gewünschten Flexibilität (Anzahl Folienlagen im flexiblen Bereich) angepasst. Der flexible Bereich weist mindestens eine Folienlage auf, der starre Bereich mindestens zwei. Starre Bereiche können zur Erhöhung ihrer Eigensteifigkeit auch noch auf ein starres Substrat aufgezogen sein.

Das Layout der erfindungsgemässen Leiterplatte wird selbstverständlich derart ausgelegt, dass die starren Bereiche bestückt werden, während in den flexiblen Bereichen lediglich Verbindungsleiter vorgesehen sind.

Folienleiterplatten mit starren und flexiblen Bereichen können wie bereits erwähnt für schwierige Platzverhältnisse zur Anwendung kommen. Es können aber auch beispielsweise Multi-chip-modules mit flexiblen Randbereichen ausgerüstet werden, die dann zur Verbindung auf eine starre Leiterplatte dienen können.

Anhand der folgenden Figuren sollen nun einige beispielhafte Ausführungsformen der erfindungsgemässen Folienleiterplatten und das Verfahren zu ihrer Herstellung detailliert beschrieben werden. Dabei zeigen, immer als Bereich im Querschnitt:
- **Figur 1**: eine Folienleiterplatte mit drei Folienlagen und vier Leiterbahnenlagen, hergestellt nach dem eingangs erwähnten Verfahren;
- **Figuren 2a bis 2c**: drei Stadien in der Herstellung einer ersten beispielhaften Ausführungsform der erfindungsgemässen Folienleiterplatte, wobei die starren Bereiche drei, der flexible Bereich zwei Folienlagen aufweisen;
- **Figuren 3a bis 3d**: vier Stadien in der Herstellung einer zweiten beispielhaften Ausführungsform der erfindungsgemässen Folienleiterplatte, wobei die starren Bereiche drei, der flexible Bereich zwei Folienlagen aufweisen und der Übergang vom starren zum flexiblen Bereich ein kontinuierlicher ist;
- **Figur 4**: eine weitere beispielhafte Ausführungsform der erfindungsgemässen Folienleiterplatte mit einem kontinuierlichen Bereichsübergang;
- **Figuren 5a bis 5d**: vier Stadien in der Herstellung einer weiteren beispielhaften Ausführungsform der erfindungsgemässen Folienleiterplatte, wobei der flexible Bereich Folienlagen mit verminderter Dicke aufweist und der Bereichsübergang ein kontinuierlicher ist.

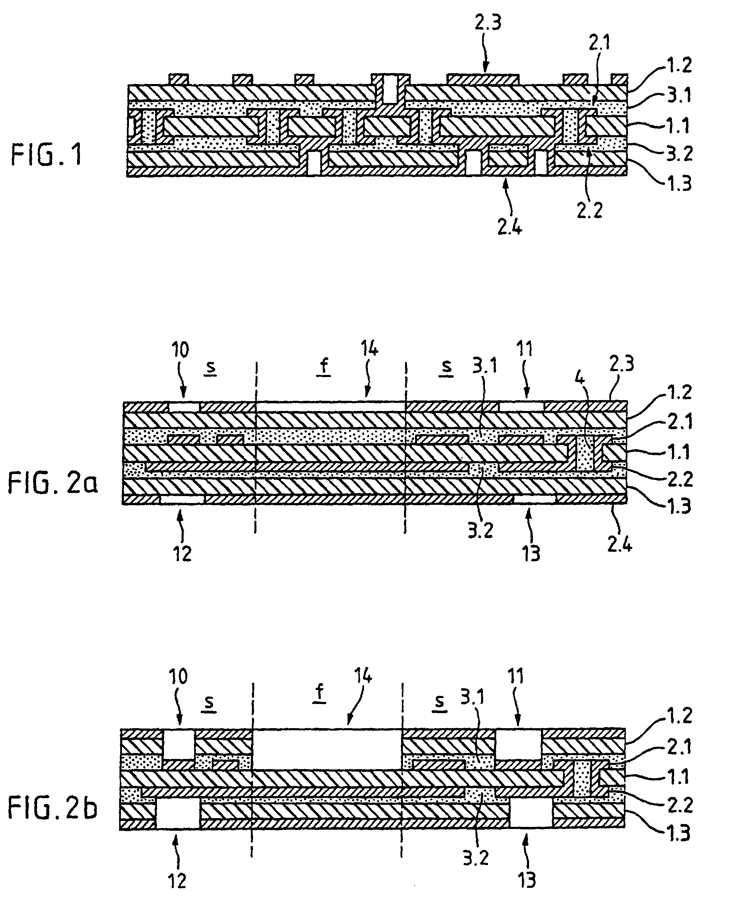

**Figur 1** zeigt einen Querschnitt durch einen Bereich einer Folienleiterplatte, wie sie zusammen mit ihrer Herstellung in der eingangs erwähnten internationalen Veröffentlichung (WO 93/26143) beschrieben ist. Die Leiterplatte besteht aus einer mittleren Folienlage (Kunststoffolie) 1.1, die Durchplattierungen und ein beidseitiges Muster von Leiterbahnen 2.1 und 2.2 aufweist. Auf der mittleren Folienlage 1.1 ist mittels Kleberschichten 3.1 und 3.2 beidseitig je eine weitere Folienlage 1.2 und 1.3 auflaminiert, die wiederum Durchkontaktierungen und ein Muster von Leiterbahnen 2.3 und 2.4 aufweist. Diese äusseren Durchkontaktierungen werden in der mit einer dünnen Metallschicht beschichteten, auflamierten Folie erstellt, indem mit photochemischen Mitteln die Metallschicht an den entsprechenden Stellen weggeätzt wird und dann die Kunststoffolie durch Plasmaätzen durchgeätzt wird. Dann wird die metallische Schicht beispielsweise galvanisch zu einer für Leiterbahnen geeigneten Dicke aufgebaut, wobei die Öffnungen gleichzeitig durchplattiert werden. In die derart erstellte metallische Schicht wird auf photochemischem Wege das Muster der Leiterbahnen eingeätzt.

**Figuren 2a bis 2c** zeigen nun, ebenfalls als Querschnitt durch einen Bereich, eine beispielhafte Ausführungsform der erfindungsgemässen Leiterplatte in drei Stadien ihrer Herstellung. Es handelt sich dabei, wie in der Figur 1, um eine Folienleiterplatte mit drei Folienlagen und vier Leiterbahnenlagen, an der zwischen zwei starren Bereichen s ein flexibler Bereich f vorgesehen ist.

**Figur 2a** zeigt die Folienleiterplatte nach dem Auflaminieren der äusseren Folienlagen 1.2 und 1.3 mit Kleberschichten 3.1 und 3.2 auf die mittlere Folienlage 1.1, die in vorangehenden Verfahrensschritten, wie bereits beschrieben, mit einem beidseitigen Leiterbahnenmuster 2.1 und 2.2 und mit Durchplattierungen 4 versehen wurde. Die Metallbeschichtungen 2.3 und 2.4 der äusseren Folienlagen 1.2 und 1.3 sind bereits an den Stellen 10, 11, 12 und 13 für Durchplattierungen und im mittleren Bereich an der Stelle 14 des vorgesehenen, flexiblen Bereiches f weggeätzt.

**Figur 2b** zeigt die Leiterplatte der Figur 2a nach einem Plasmaätzschritt, in dem die nicht durch Metall abgedeckten Stellen 10 bis 14 der Kunststoffolie abgetragen wurden. An den Stellen 10 bis 13 sind dadurch Sacklöcher bis auf die Leiter der Leiterbahnenlagen 2.1 bzw. 2.2 entstanden, an der Stelle 14 eine grösserflächige Öffnung in der Folienlage 1.2, wobei auch die Kleberschicht 3.1 abgetragen ist.

Die Ätzparameter für das Plasmaätzen des beschriebenen Schrittes müssen derart eingestellt werden, dass die Sacklöcher genügend tief aber ohne unerwünschte Unterätzung geätzt werden. In demselben Ätzschritt, also mit denselben Ätzpararnetern sollen im flexiblen Bereich f die Kunststoffolie 1.2 und die Kleberschicht 3.1 wegeätzt werden. Das heisst, die Anforderungen an die Ätzung an den Stellen 10 bis 13 sind nicht genau gleich wie die Anforderungen an die Ätzung an der Stelle 14. Die Ätzung in einem Schritt ist trotzdem möglich, wenn beispielsweise Polyimidfolien und Polyimid-Kleberschichten verwendet werden, wobei die Kleberschicht vor dem Plasmaätzen nicht oder nur unvollständig ausgehärtet wird. Dadurch setzt die Kleberschicht dem Ätzen einen viel geringeren Widerstand entgegen und wird sehr schnell weggeätzt sodass der an der Stelle 14 tiefere Ätzvorgang zu keiner unerwünschten Unterätzung an den Stellen 10 bis 13 führt. Es kann je nach Anwendung aber auch tolerierbar sein, wenn Reste der Kleberschicht an der Stelle 14 zurückbleiben.

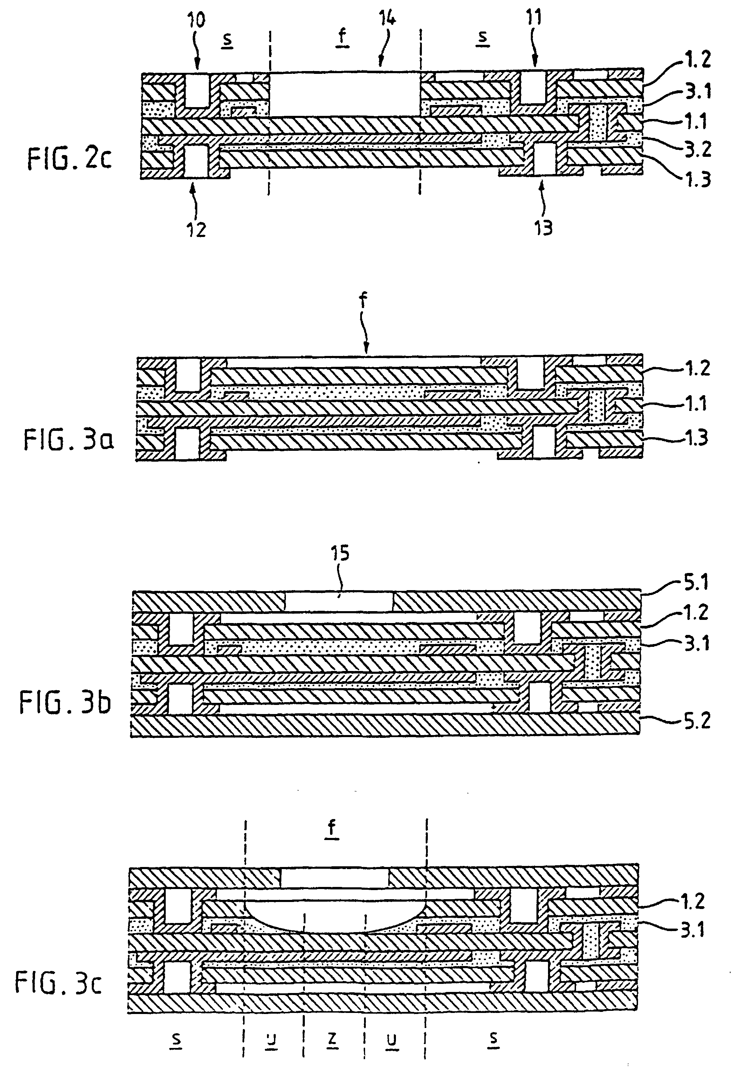

**Figur 2c** zeigt denselben Bereich der fertigen Leiterplatte nach dem Durchplattieren der Sacklöcher an den Stellen 10 bis 13 und dem photochemischen Erstellen der Leiterbahnenmuster an den beiden Oberflächen der Leiterplatte. Wie aus der Figur ersichtlich ist, weist die fertige Leiterplatte in ihren starren Bereichen s drei (1.1, 1.2, 1.3) Folienlagen (vier Leiterbahnenlagen) auf, in ihrem flexiblen Bereich zwei (1.1, 13) Folienlagen (beispielsweise eine Leiterbahnenlage).

**Figuren 3a bis 3d** zeigen ein weiteres Verfahren zur Herstellung von erfindungsgemässen Folienleiterplatten, wobei flexible Bereiche mit einem kontinuierlichen Übergang zu den starren Bereichen hergestellt werden können. Das Verfahren unterscheidet sich vom im Zusammenhang mit den Figuren 2a bis 2c beschriebenen Verfahren dadurch, dass der Ätzschritt zur Erzeugung der flexiblen Bereiche nicht derselbe ist wie der Ätzschritt zur Erzeugung der Sacklöcher. Dadurch fällt der Zwang der gleichen Ätzparameter weg, was zu bedeutend mehr Freiheitsgraden führt, das Verfahren aber aufwendiger werden lässt.

**Figur 3a** zeigt eine Folienleiterplatte mit drei Folienlagen 1.1, 1.2 und 1.3 (vier Leiterbahnenlagen), deren Leiterbahnenmuster auf den beiden Oberflächen mit den Sacklöchern zu den tiefer liegenden Leiterbahnen bereits fertig gestellt ist. Im mittleren Bereich, der zu einem flexiblen Bereich f umgestaltet werden soll, weist die Leiterplatte nur innere Leiter auf.

Auf diese Folienleiterplatte wird nun, wie in der **Figur 3b** dargestellt, beidseitig eine Metallmaske 5.1 und 5.2 (z.B. aus Edelstahl) gepresst, die im vorgesehenen flexiblen Bereich f beispielsweise einseitig Aussparungen 15 aufweist.

Wird nun die mit der aufgepressten Maske versehene Leiterplatte einem weiteren Plasmaätzschritt unterzogen, entsteht beispielsweise die Leiterplatte gemäss **Figur 3c** in der im flexiblen Bereich f die durch die Metallmaske zugängliche Kunststoffolie angegriffen worden ist. Je nach Wahl der Ätzparameter und des Abstandes der Maske vom Substrat können Unterätzungen, wie in der Figur 3c dargestellt, erreicht werden, derart, dass von Randbereichen u des flexiblen Bereiches f, in denen die Abtragung geringer ist, die Dicke der Folienlage 2.1 und der Kleberschicht 3.1 gegen einen Zentrumsbereich z sukzessive abnimmt.

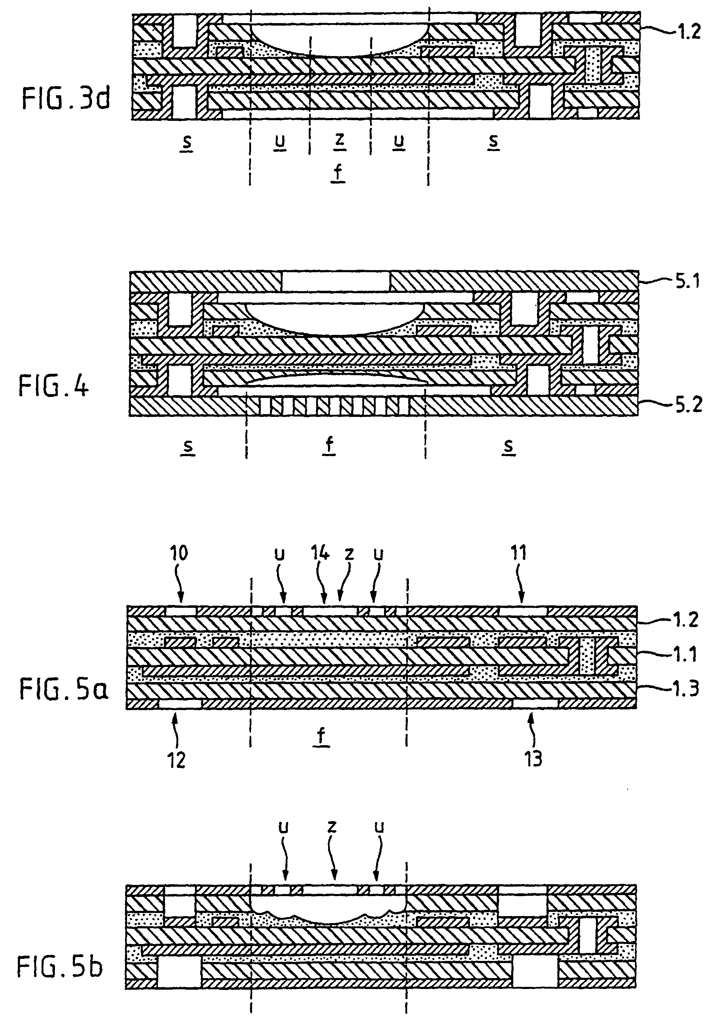

**Figur 3d** zeigt die fertige Folienleiterplatte mit dem kontinuierlichen Übergang zwischen flexiblem Bereich f und starren Bereichen s. Es ist vorstellbar, dass auf diese Folienleiterplatte weitere Folienlagen auflaminiert werden, die im flexiblen Bereiche f wiederum, beispielsweise nach dem im Zusammenhang mit den Figuren 2a bis 2c beschriebenen Verfahren weggeätzt werden.

**Figur 4** zeigt eine weitere, beispielhafte Ausführungsform der erfindungsgemässen Folienleiterplatte. Das Herstellungsstadium ist dasselbe, wie das in der Figur 3c dargestellte. Auf die bis auf die flexiblen Bereiche f fertiggestellte Leiterplatte sind beidseitig Metallmasken 5.1 und 5.2 mit Öffnungen in den vorgesehenen flexiblen Bereichen aufgepresst worden, dann ist die Leiterplatte einem Plasmaätzschritt unterzogen worden. Der Abtrag des Folienmaterials durch den Ätzschritt ist, wie bereits erwähnt, abhängig von den Ätzparametern und den Formen und Anordnungen der Öffnungen in der Maske. Dies geht deutlich aus einem Vergleich der in der Figur 4 gegen oben und der gegen unten gewandten Abtragung hervor. Oben ist die Unterätzung der Figur 3c dargestellt, die durch eine einzige Maskenöffnung und Unterätzung entsteht. Auf der unteren Seite wurde zur Verminderung des Abtrages nicht eine einzige Öffnung in der Maske angebracht, sondern eine Serie kleinerer Öffnungen. Damit kann die Ätzrate bei gleichbleibenden Ätzparametern herabgesetzt werden, was an dieser Unterseite vorteilhaft ist, denn bei höherer Ätzrate wären die Leiterbahnen freigelegt worden, was im flexiblen Bereich nicht unbedingt erwünscht ist.

**Figuren 5a bis 5d** zeigen nun noch ein Verfahren, mit dem ähnliche flexible Bereiche erstellt werden können wie mit dem Verfahren, das im Zusammenhang mit den Figuren 3 und 4 beschrieben wurde, bei dem aber kein spezieller Ätzschritt für die flexiblen Bereiche f notwendig ist, das heisst, bei dem die flexiblen Bereiche mit den Sacklöchern, also bei durch diese Sacklöcher gegebenen Ätzparametern erstellt werden.

**Figur 5a** zeigt eine Folienleiterplatte mit drei Folienlagen 1.1, 1.2 und 1.3. Die Metallbeschichtungen der äusseren Folienlagen sind bereits weggeätzt an Stellen 10 bis 13 für Sacklöcher und an der Stelle 14 für den vorgesehenen flexiblen Bereich f. An der Stelle 14 ist ein Öffnungsmuster vorgesehen, das beispielsweise grössere Öffnungen im Zentrum z des Bereiches und kleinere Öffnungen gegen den Rand u des Bereiches aufweist

**Figur 5b** zeigt dieselbe Leiterplatte nach dem Plasmaätzen. Es ist offensichtlich, dass die Öffnungsgrösse die Ätzrate bestimmt und dass diese dadurch im Zentrum z des flexiblen Bereiches höher ist als in dessen Randbereichen u. Auch auf diese Weise kann ein flexibler Bereich mit kontinuierlichem Übergangsbereich zum starren Bereich erstellt werden.

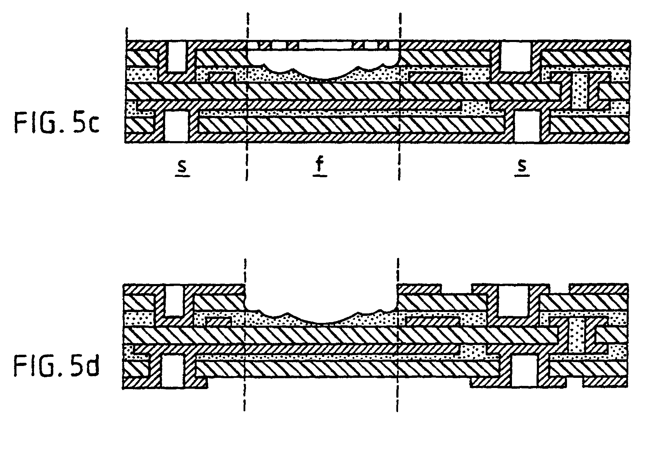

**Figuren 5c und 5d** zeigen noch die Fertigstellung der Leiterplatte durch galvanisches Aufbauen der Metallschicht und Durchplattieren der Sacklöcher und durch photochemisches Erstellen der äussersten Leiterbahnenmuster, wobei auch die sich siebartig über den flexiblen Bereich f spannende Metallschicht weggeätzt wird.

Es ist selbstverständlich, dass in allen beschriebenen Fällen der flexible Bereich auch durch Schwächen oder vollständiges Abtragen beider äusseren Folienlagen hätte gebildet werden können. Ebenfalls ist es selbstverständlich, dass in derselben Art an Folienleiterplatten mit mehr als drei Folienlagen flexible Bereiche erstellt werden können, wobei eine oder beide der äussersten Folienlagen geschwächt oder unterbrochen wird oder zusätzlich auch die nächst inneren Folienlage oder Folienlagen.

In analoger Weise ist das erfindungsgemässe Verfahren auch anwendbar für Folienleiterplatten, deren äussere Lagen durch Auflaminieren einer Metallschicht mit Hilfe einer Kleberfolie erstellt werden, derart, dass die Kunststoffschicht zwischen den entsprechenden Leiterlagen nicht wie in den beschriebenen Beispielen dargestellt zweischichtig, sondern nur einschichtig ist.

## Patentansprüche

1. Folienleiterplatte,
mit isolierenden Folienlagen (1.1, 1.2, 1.3), Leiterbahnlagen (2.1, 2.2, 2.3, 2.4) und die Folienlagen miteinander verbindende Kleberschichten (3.1, 3.2),
wobei mindestens ein flexibler Bereich (f) vorgesehen ist, in welchem Folienlagen dickenvermindert oder unterbrochen sind,
**dadurch gekennzeichnet,**
**dass** drei Folienlagen (1.1, 1.2, 1.3) vorhanden sind,
wovon eine erste Folienlage (1.1) beidseitig mit einer Leiterbahnenlage (2.1, 2.2) versehen ist,
wovon eine zweite Folienlage (1.2) mittels einer ersten Kleberschicht (3.1) mit der einen, mit einer Leiterbahnenlage (2.1) versehenen Seite der ersten Folienlage (1.1) verbunden ist,
und wovon eine dritte Folienlage (1.3) mittels einer zweiten Kleberschicht (3.2) mit der anderen, mit einer Leiterbahnenlage (2.2) versehenen Seite der ersten Folienlage (1.1) verbunden ist,
**dass** im flexiblen Bereich (f) die zweite Folienlage (1.2) unterbrochen ist und die an diese angrenzende erste Kleberschicht (3.1) unterbrochen oder durch Dickenverminderung geschwächt ist,
und **dass** auf den äusseren Oberflächen der Folienleiterplatte Leiterbahnenlagen (2.3, 2.4) angeordnet sind.

2. Folienleiterplatte nach Anspruch 1, **dadurch gekennzeichnet, dass** die Dicke der zweiten Folienlage (1.2) und der ersten Kleberschicht (3.1) gegen das Zentrum (z) des flexiblen Bereiches (f) kontinuierlich abnimmt.

3. Verfahren zur Herstellung einer Folienleiterplatte mit flexiblen Bereichen (f) nach einem der Ansprüche 1 bis 2,
wobei von einer Folienleiterplatte mit drei isolierenden Folienlagen (1.1, 1.2, 1.3) ausgegangen wird, dass drei Folienlagen (1.1, 1.2, 1.3) vorhanden sind,
wovon eine erste Folienlage (1.1) beidseitig mit einer Leiterbahnenlage (2.1, 2.2) versehen ist,
wovon eine zweite Folienlage (1.2) mittels einer ersten Kleberschicht (3.1) mit der einen, mit einer Leiterbahenlage (2.1) versehenen Seite der ersten Folienlage (1.1) verbunden ist,
und wovon eine dritte Folienlage (1.3) mittels einer zweiten Kleberschicht (3.2) mit der anderen, mit einer Leiterbahnenlage (2.2) versehenen Seite der ersten Folienlage (1.1) verbunden ist,
wobei in vorgesehenen flexiblen Bereichen (f) die zweite Folienlage (1.2) durch Plasmaätzen so weit abgetragen wird, dass sie unterbrochen ist,
und wobei in demselben Plasmaätzschritt und in denselben Bereichen die daran angrenzende erste Kleberschicht (3.1) vollständig abgetragen oder in ihrer Dicke vermindert wird.

4. Verfahren nach Anspruch 3, wobei die zweite und dritte Folienlage (1.2, 1.3) je mit einer äussersten Leiterschicht (2.3, 2.4) versehen werden, welche vor dem Plasmaätzschritt an Stellen für Durchplattierungen und in den vorgesehenen flexiblen Bereichen (f) Aussparungen (10, 11, 12, 13, 14) aufweisen, wobei im Plasmaätzschritt gleichzeitig zu den flexiblen Bereichen auch Sacklöcher für die Durchplattierungen erzeugt werden, und wobei anschliessend an den Plasmaätzschritt die äussersten Leiterschichten (2.3, 2.4) zu einem Leiterbahnenmuster strukturiert werden.

5. Verfahren nach Anspruch 3, wobei die zweite Folienlage (1.2) und die darunter liegende Kleberschicht (3.1) durch eine aufgepresste Maske (5.1, 5.2) mit Öffnungen in den vorgesehenen flexiblen Bereichen (f) vollständig abgetragen oder in ihrer Dicke vermindert werden.

6. Verfahren nach Anspruch 5, wobei die zweite und dritte Folienlage (1.2, 1.3) der Folienleiterplatte, von welcher ausgegangen wird, bereits je mit einer äussersten, zu einem Leiterbahnenmuster strukturierten Leiterschicht (2.3,2.4) versehen sind.

7. Verfahren nach Anspruch 5 oder 6, wobei die zweite Folienlage (1.2) und die darunter liegende erste Kleberschicht (3.1) in Randbereichen (u) des vorgesehenen flexiblen Bereiches (f) durch das Plasmaätzen weniger angegriffen werden als im Zentrum (z) des vorgesehenen flexiblen Bereiches, dadurch, dass die Maskenöffnungen kleiner sind als der vorgesehene flexible Bereich (f) und unterätzt werden.

8. Verfahren nach Anspruch 5 oder 6, wobei die zweite Folienlage (1.2) und die darunter liegende erste Kleberschicht (3.1) in den Randbereichen (u) des vorgesehenen flexiblen Bereiches (f) durch das Ätzen weniger angegriffen werden als im Zentrum (z) des vorgesehenen flexiblen Bereiches, dadurch, dass die Maskenöffnungen im Randbereich (u) kleiner sind als im Zentrumsbereich (z).

## Claims

1. Foil printed circuit board,
comprising insulating foil layers (1.1, 1.2, 1.3), conductor layers (2.1, 2.2, 2.3, 2.4) and adhesive layers (2.1, 2.2, 2.3, 2.4) connecting the foil layers,
wherein at least one flexible region (f) is provided, in which the foil layers are of reduced thickness or are interrupted,
**characterized**
**in that** three foil layers (1.1) are provided,
of which a first foil layer (1.1) is equipped with a conductor layer (2.1, 2.2) on both sides,
of which a second foil layer (1.2) is connected to the one side of the first foil layer (1.1) by means of a first adhesive layer (3.1), said one side of the first foil layer (1.1) carrying a conductor layer (2.1),
and of which a third foil layer (1.3) is, by means of a second adhesive layer (3.2), connected to the other side of the first foil layer (1.1) carrying a conductor layer (2.2),
**in that** in the flexible region (f) the second foil layer (1.2) is interrupted and the adjacent first adhesive layer (3.1) is interrupted or weakened by reduced thickness,
and that on the outermost surfaces of the foil conductor board conductor layers (2.3, 2.4) are arranged.

2. Foil printed circuit board according to claim 1, **characterized in that** the thickness of the second foil layer (1.2) and of the first adhesive layer (3.1) continuously decreases towards the center (z) of the flexible region (f).

3. Method for manufacture of a foil printed circuit board with flexible regions (f) according to claim 1 or 2,
wherein a board consisting of three insulating foil layers (1.1, 1.2, 1.3) is used, of which a first foil layer (1.1) is equipped with a conductor layer (2.1, 2.2) on both sides,
a second foil layer (1.2) is connected to the one side of the first foil layer (1.1) by means of a first adhesive layer (3.1), said one side of the first foil layer (1.1) carrying a conductor layer (2.1),
and a third foil layer (1.3) is, by means of a second adhesive layer (3.2), connected to the other side of the first foil layer (1.1) equipped with a conductor layer (2.2),
wherein in provided flexible regions (f) the second foil layer (1.2) is reduced by means of plasma etching to a degree that it is interrupted,
and wherein in the same plasma etching step and in the same regions the adjacent first adhesive layer (3.1) is completely removed or reduced in its thickness.

4. Method according to claim 3, wherein the second and third foil layers (1.2, 1.3) are equipped with an outermost conductor layer (2.3, 2.4) which, before etching, in locations for plated through holes and in the provided flexible regions (f), comprise recesses (10, 11, 12, 13, 14), wherein in the plasma etching step blind holes for the plated through holes are created simultaneously with the flexible regions and wherein subsequently to the plasma etching step the outermost conductor layers (2.3, 2.4) are structured to form a pattern of conductor paths.

5. Method according to claim 3, wherein the second foil layer (1.2) and the underlying adhesive layer (3.1) is completely removed or undergoes a reduction in thickness through a pressed on mask (5.1, 5.2) with openings in the provided flexible regions (f).

6. Method according to claim 5, wherein the second and third foil layers (1.2, 1.3) of the foil printed circuit board, which is used, are each provided with an outermost conductor layer (2.3, 2.4), which is structured to form a pattern of conducting paths.

7. Method according to claim 5 or 6, wherein the second foil layer (1.2) and the underlying first adhesive layer (3.1) is affected to a lesser degree by the plasma etching in marginal regions (u) of the provided flexible region than in the center (z) of the provided flexible region due to the openings in the mask being smaller than the provided flexible region (f) and are undercut.

8. Method according to claim 5 or 6, wherein the second foil layer (1.2) and the underlying first adhesive layer (3.1) is affected to a lesser degree by the plasma etching in marginal regions (u) of the provided flexible region than in the center (z) of the provided flexible region due to the openings in the mask being smaller in the marginal region (u) than in the center region (z).

## Revendications

1. Carte de circuit imprimé en feuilles, présentant des couches en feuille isolantes (1.1, 1.2, 1.3), des couches à pistes conductrices (2.1, 2.2, 2.3, 2.4) et des couches d'adhésif (3.1, 3.2) qui relient les unes aux autres les couches en feuille,
au moins une zone flexible (f) dans laquelle les couches en feuille présentent une épaisseur réduite ou sont interrompues, étant prévues,
**caractérisée en ce que** trois couches en feuille (1.1, 1.2, 1.3) sont prévues,
parmi lesquelles une première couche en feuille (1.1) est dotée sur ses deux côtés d'une couche de pistes conductrices (2.1, 2.2),
une deuxième couche en feuille (1.2) est reliée au moyen d'une première couche d'adhésif (3.1) à l'un des côtés de la première couche en feuille (1.1), doté d'une couche de pistes conductrices (2.1) et
une troisième couche en feuille (1.3) est reliée au moyen d'une deuxième couche d'adhésif (3.2) à l'autre côté de la première couche en feuille (1.1), doté d'une couche de pistes conductrices (2.2),
**en ce que** dans la zone flexible (f), la deuxième couche en feuille (1.2) est interrompue et la première couche d'adhésif (3.1) adjacente à elle est interrompue ou est affaiblie par diminution d'épaisseur et
**en ce que** des couches de pistes conductrices (2.3, 2.4) sont disposées sur la surface extérieure de la carte de circuit imprimé en feuilles.

2. Carte de circuit imprimé en feuilles selon la revendication 1, **caractérisée en ce que** l'épaisseur de la deuxième couche en feuille (1.2) et de la première couche d'adhésif (3.1) diminue de manière continue en direction du centre (z) de la zone flexible (f).

3. Procédé pour la fabrication d'une carte de circuit imprimé en feuilles dotée de zones flexibles (f) selon l'une des revendications 1 à 2,
dans lequel on part d'une carte de circuit imprimé en feuilles présentant trois couches en feuille isolante (1.1, 1.2, 1.3), de telle sorte que trois couches en feuille (1.1, 1.2, 1.3) soient présentes, parmi lesquelles
une première couche en feuille (1.1) est dotée des deux côtés d'une couche de pistes conductrices (2.1, 2.2),
une deuxième couche en feuille (1.2) est reliée au moyen d'une première couche d'adhésif (3.1) à l'un des côtés de la première couche en feuille (1.1), doté d'une couche de pistes conductrices (2.1) et
une troisième couche en feuille (1.3) est reliée au moyen d'une deuxième couche d'adhésif (3.2) à l'autre côté de la première couche en feuille (1.1) dotée d'une couche de pistes conductrices (2.2) et
dans les zones flexibles (f) prévues, la deuxième couche en feuille (1.2) est enlevée par gravure au plasma dans une mesure telle qu'elle soit interrompue et
la première couche d'adhésif (3.1) adjacente est entièrement enlevée ou a son épaisseur réduite lors de la même étape de gravure au plasma et dans les mêmes zones.

4. Procédé selon la revendication 3, dans lequel la deuxième et la troisième couche en feuille (1.2, 1.3) sont chacune dotées d'une couche extérieure de conducteurs (2.3, 2.4) qui, avant l'étape de gravure au plasma présente des découpes (10, 11, 12, 13, 14) prévues en des emplacements prévus pour un plaquage perforant et dans les zones flexibles (f), tandis que lors de l'étape de gravure au plasma, en même temps que les zones flexibles, des trous aveugles sont également créés pour les plaquages perforants, et après l'étape de gravure au plasma, les couches extérieures de conducteurs (2.3, 2.4) sont structurées pour fournir un motif de pistes conductrices.

5. Procédé selon la revendication 3, dans lequel la deuxième couche en feuille (1.2) et la couche d'adhésif (3.1) située par dessous sont enlevées complètement ou ont leur épaisseur diminuée par un masque (5.1, 5.2) appliqué contre elles et doté d'ouvertures dans les zones flexibles (f) prévues.

6. Procédé selon la revendication 5, dans lequel la deuxième et la troisième couches en feuille (1.2, 1.3) de la carte de circuit en feuilles de laquelle on part, sont déjà dotées d'une couche extérieure de conducteurs (2.3, 2.4) structurée en un motif de pistes conductrices.

7. Procédé selon la revendication 5 ou 6, dans lequel la deuxième couche en feuille (1.2) et la première couche d'adhésif (3.1) située par dessous sont moins attaquées dans des zones de bordure (u) de la zone flexible (f) prévues par la gravure au plasma qu'au centre (z) de la zone flexible prévue, de telle sorte que les ouvertures de masque soient plus petites que la zone flexible (f) prévue et sont moins gravées.

8. Procédé selon la revendication 5 ou 6, dans lequel la deuxième couche en feuille (1.2) et la première couche d'adhésif (3.1) situées par dessous sont moins attaquées par la gravure au plasma dans les zones de bordure (u) de la zone flexible (f) prévue que dans le centre (z) de la zone flexible prévue, de telle sorte que les ouvertures de masque soient plus petites dans la zone de bordure (u) que dans la zone centrale (z).
